# EUROPEAN PATENT APPLICATION

(11) **EP 1 662 656 A1**
(43) Date of publication of application: **31.05.2006**
(21) Application number: 05257260.9
(22) Date of filing: 25.11.2005
(51) Int. Cl.: H03K 5/08, H03K 5/156

(54) **Duty cycle correction circuit**

(30) Priority: 26.11.2004 KR 2004097942
(71) Applicant: Samsung Electronics Co., Ltd., Suwon-si, Gyeonggi-Do (KR)
(72) Inventor: Lee, Heon-soo, Giheung-eub Yongin-si Gyeonggi-dop (KR); Lee, Byeong-Hoon, Mepo-gu Seoul (KR)
(74) Representative: Mounteney, Simon James

(57) **Abstract**

A compact duty cycle correction circuit including minimal components for generating a signal with a 50% duty cycle. The duty cycle correction circuit includes a storage element and a correction circuit. The storage element generates an output signal in response to a clock signal and a feedback signal. The correction circuit includes a resistor and a capacitor and outputs the feedback signal in response to the output signal of the storage element.

## Description

### BACKGROUND OF THE INVENTION

This application claims the priority of Korean Patent Application No. 10-2004-0097942, filed on November 26, 2004, in the Korean Intellectual Property Office, the contents of which are incorporated herein in their entirety by reference.

### 1. Field of the Invention

The present invention relates to a circuit for generating a digital signal, and more particularly, to an apparatus for generating a signal with a 50% duty cycle.

### 2. Description of the Related Art

In general, high-speed devices such as analog-to-digital converters (ADCs) or double data rate (DDR) SDRAMs use both the rising and falling edges of clock signals. When both the rising edges and falling edges of a clock signal are used, a 50% duty cycle of the clock signalshould be maintained to ensure a sufficient design margin of a system. Various circuits have been developed to generate a clock signal with a 50% duty cycle, each including a clock generation circuit and a clock driver circuit. However, the 50% duty cycle of a clock signal generated by the clock generation circuit can change, due to miss-match of a pull-up circuit and a pull-down circuit of the clock driver circuit connected to the clock generation circuit. For this reason, in order to stably generate a clock with a 50% duty cycle, a duty cycle correction circuit is needed in these conventional systems.

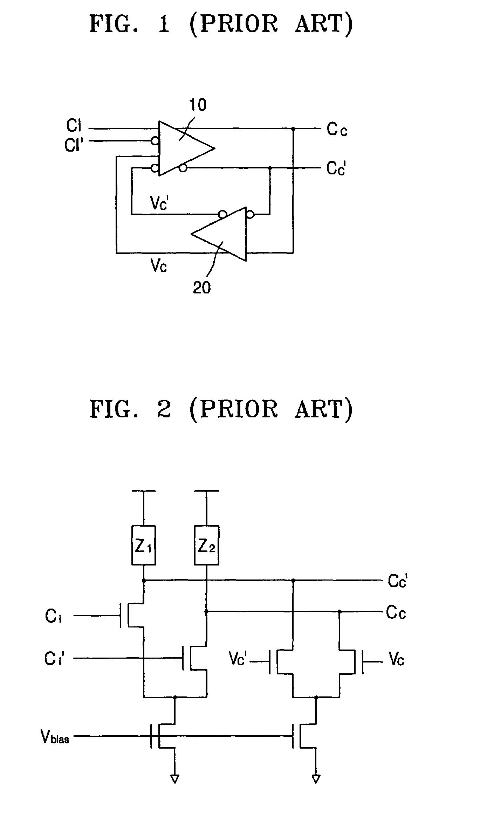

FIG. 1 is a circuit diagram of a conventional duty cycle correction circuit.

Referring to FIG. 1, the duty cycle correction circuit may be an analog circuit including two function blocks. The first function block 10 performs a correction function and the second function block 20 acts as a control voltage generator.

FIG. 2 is a circuit diagram of the first function block 10 shown in FIG. 1.

FIG. 3 is a circuit diagram of the second function block 20 shown in FIG. 1.

The second function block 20 generates as control voltages differential analog offset voltages Vc and Vc', which are differences between clock duty cycles of differential clock signals Cc and Cc'. The first function block 10 corrects the duty cycles of input clock signals Ci and Ci' using as control voltages the differential analog offset voltages Vc and Vc', which are stored in capacitors C1 and C2.

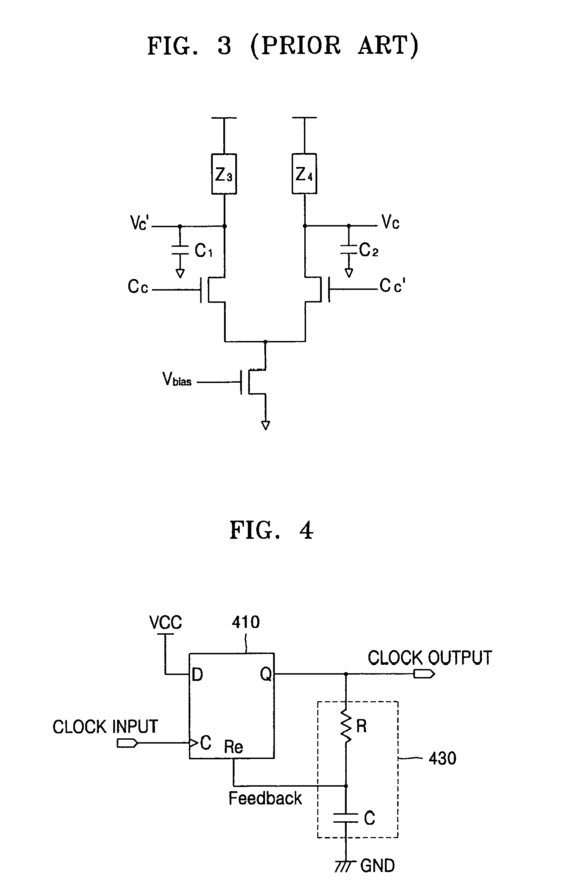

In FIGS. 2 and 3, Z1 through Z4 represent impedances.

As seen in FIGS. 1 through 3, since a conventional duty cycle correction circuit for generating a clock signal with a 50% duty cycle includes many devices, power consumption is high and a large area is needed.

### SUMMARY OF THE INVENTION

The present invention provides a compact duty cycle correction circuit including minimal components for generating a signal with 50% duty cycle.

According to an aspect of the present invention, there is provided a duty cycle correction circuit including a storage element and a correction circuit. The storage element generates an output signal in response to a clock signal and a feedback signal. The correction circuit outputs the feedback signal in response to the output signal of the storage element.

In one embodiment, the storage element is a flip-flop that activates the output signal in response to a rising edge of the clock signal and resets the output signal in response to the feedback signal.

In one embodiment, the storage element has an input terminal to which a DC voltage is applied, a clock terminal to which the clock signal is applied, and a reset terminal to which the feedback signal is applied.

In one embodiment, the correction circuit includes a resistor and a capacitor. The resistor is connected between an output terminal of the storage element and a node from which the feedback signal is output. The capacitor is connected between the node from which the feedback signal is output and a supply voltage.

In one embodiment, the resistance of the resistor and the capacitance of the capacitor are set according to the frequency of the clock signal. The resistance of the resistor and the capacitance of the capacitor can be variable.

### BRIEF DESCRIPTION OF THE DRAWINGS

The foregoing and other objects, features and advantages of the invention will be apparent from the more particular description of preferred aspects of the invention, as illustrated in the accompanying drawings in which like reference characters refer to the same parts throughout the different views. The drawings are not necessarily to scale, emphasis instead being placed upon illustrating the principles of the invention.
FIG. 1 is a circuit diagram of a conventional duty cycle correction circuit.
FIG. 2 is a circuit diagram of a first function block shown in FIG. 1.
FIG. 3 is a circuit diagram of a second function block shown in FIG. 1.
FIG. 4 is a circuit diagram of a duty cycle correction circuit according to an embodiment of the present invention.

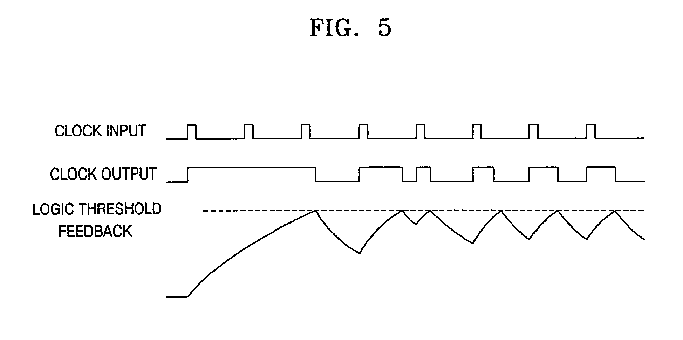

FIG. 5 is a signal diagram of the duty cycle correction circuit shown in FIG. 4.

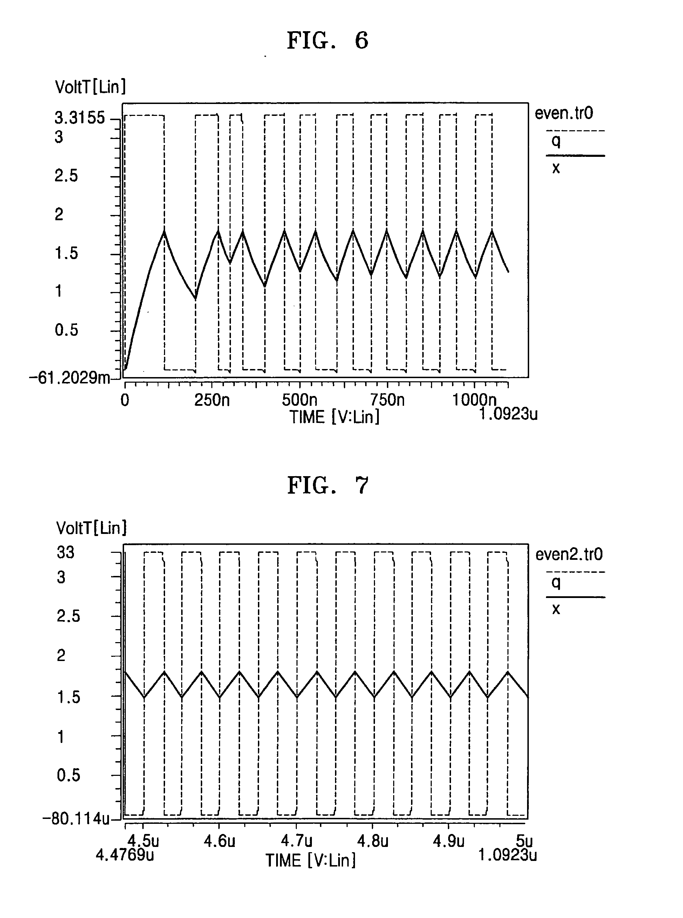

FIG. 6 is a signal of feedback voltage versus time when a 10 MHz input signal with a 10% duty cycle is input to the duty cycle correction circuit shown in FIG. 4.
FIG. 7 is a graph of feedback voltage versus time when a 20 MHz input signal with a 10% duty cycle is input to the duty cycle correction circuit shown in FIG. 4.

### DETAILED DESCRIPTION OF THE INVENTION

FIG. 4 is a circuit diagram of a duty cycle correction circuit according to an embodiment of the present invention.

Referring to FIG. 4, the duty cycle correction circuit includes a storage element 410 and a correction circuit 430.

The storage element 410 operates in response to a clock signal and a feedback signal. If the storage element 410 is a flipflop, the clock signal is input to a clock terminal C of the flipflop 410, a constant voltage VCC is applied to an input terminal D of the flipflop 410, and the feedback signal is input to a reset terminal Re of the flipflop 410.

The correction circuit 430 includes a resistor R and a capacitor C connected in series.

The resistor R is connected between the capacitor C and an output terminal Q of the flipflop 410. A common node of the resistor R and the capacitor C is connected to the reset terminal Re of the flipflop 410.

FIG. 5 is a signal diagram of the duty cycle correction circuit shown in FIG. 4.

Referring to FIGS. 4 and 5, a voltage obtained by sampling a voltage applied to the input terminal D at a rising edge of a clock input signal is output as a clock output signal. The correction circuit 430 generates a feedback signal according to the clock output signal and supplies the feedback signal to the reset terminal Re of the flipflop 410.

The voltage of the feedback signal is changed due to the resistor R and the capacitor C of the correction circuit 430 in response to the clock output signal. That is, the voltage of the clock output signal charges the capacitor C at a rate proportional to the resistance of the resistor R and the capacitance of the capacitor C. The voltage stored in the capacitor C is the voltage of the feedback signal.

If the voltage of the feedback signal reaches a logic threshold voltage of the reset terminal Re of the flipflop 410, the clock output signal of the storage element 410 transits to a low state. Then, charges stored in the capacitive element C are discharged, thereby reducing the voltage of the feedback signal.

The above-described process is repeated, so that the feedback signal becomes a stable saw-tooth wave and the clock output signal becomes a signal with 50% duty cycle.

Here, the resistance and capacitance of the resistor R and the capacitor C are set according to the frequency of the clock input signal.

FIG. 6 is a graph of feedback voltage versus time when a 10 MHz input signal with a 10% duty cycle is the clock input to the duty cycle correction circuit shown in FIG. 4 applied to the clock terminal C of the flip-flop 410.

FIG. 7 is a graph of feedback voltage versus time when a 20 MHz input signal with a 10% duty cycle is the clock input to the duty cycle correction circuit shown in FIG. 4 applied to the clock terminal C of the flip-flop 410.

Referring to FIGS. 6 and 7, a dashed rectangular signal represents the voltage of the clock output signal and a solid saw-tooth signal represents the voltage of the feedback signal.

FIGS. 6 and 7 illustrate the saturation time for achieving a 50% duty cycle signal, when SPICE is used as a circuit simulator and the resistance of the resistor R and the capacitance of the capacitor C are fixed. As seen in FIGS. 6 and 7, as the frequency of the clock input signal increases, the saturation time decreases.

In the duty cycle correction circuit according to the present invention, the resistance of the resistor R and the capacitance of the capacitor C can be changed to achieve a wide-range input frequency.

As described above, the duty cycle correction circuit according to the present invention occupies a smaller area within a semiconductor device and has significantly less consumption power than a conventional duty cycle correction circuit using an analog method.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A duty cycle correction circuit comprising:
a storage element generating an output signal in response to a clock signal and a feedback signal; and
a correction circuit outputting the feedback signal in response to the output signal of the storage element.

2. The circuit of claim 1, wherein the storage element is a flipflop that activates the output signal in response to a rising edge of the clock signal and resets the output signal in response to the feedback signal.

3. The circuit of claim 1, wherein the storage element has an input terminal to which a DC voltage is applied, a clock terminal to which the clock signal is applied, and a reset terminal to which the feedback signal is applied.

4. The circuit of claim 1, wherein the correction circuit comprises:
a resistor connected between an output terminal of the storage element and a node from which the feedback signal is output; and
a capacitor connected between the node from which the feedback signal is output and a supply voltage.

5. The circuit of claim 4, wherein the resistance of the resistor and the capacitance of the capacitor are set according to the frequency of the clock signal.

6. The circuit of claim 5, wherein the resistance of the resistor and the capacitance of the capacitor are variable.
